# EUROPÄISCHE PATENTSCHRIFT

(11) **EP 1 788 112 B1**
(45) Veröffentlichungstag und Bekanntmachung des Hinweises auf die Patenterteilung: **17.08.2011**
(21) Anmeldenummer: 05023354.3
(22) Anmeldetag: 26.10.2005
(51) Int. Cl.: C23C 14/04, C23C 14/56, H01G 13/00

(54) **Vorrichtung zum Bedampfen von Substraten**
Vapour deposition apparatus
Dispositif pour revêtir par évaporation

(43) Veröffentlichungstag der Anmeldung: 23.05.2007
(73) Patentinhaber: Applied Materials GmbH & Co. KG, 63755 Alzenau (DE)
(72) Erfinder: Klemm, Günter, 61667 Nidda (DE)
(74) Vertreter: Schickedanz, Willi

(56) Entgegenhaltungen:
- EP-A- 0 494 340
- EP-A- 1 493 836
- DE-A1- 3 922 187
- DE-A1- 19 843 818
- DE-A1- 19 848 177
- PATENT ABSTRACTS OF JAPAN Bd. 2003, Nr. 12, 5. Dezember 2003 (2003-12-05) -& JP 2004 214185 A (SONY CORP), 29. Juli 2004 (2004-07-29)

## Beschreibung

Die Erfindung betrifft eine Vorrichtung zum Bedampfen von Substraten nach dem Oberbegriff des Patentanspruchs 1.

Kunststofffolien werden oft im Vakuum mit einer Metallschicht versehen, beispielsweise um sie gasundurchlässig oder elektrisch leitfähig zu machen. Sollen nicht alle Bereiche leitfähig gemacht werden, sondern nur bestimmte Bahnen, werden diejenigen Bereiche, die keine Metallschicht erhalten sollen, mit Ölfilm-Streifen versehen, die bewirken, dass kein Metall an der Folie haften bleibt. Diese Ölfilm-Streifen werden mittels eines Ölverdampfers aufgebracht.

Es ist bereits eine Vorrichtung zum Herstellen von metallfreien Streifen bei im Vakuum beschichteten Folienbahnen, insbesondere für Kondensatoren bekannt, bei welcher ein mit Öl gefülltes Gefäß vorgesehen ist, das mindestens ein Dampfaustrittsrohr aufweist (DE 39 22 187 A1). Die Austrittsdüse dieses Dampfaustrittsrohrs mündet dabei unterhalb des Oberflächenniveaus des Öls in die Beschichtungskammer in unmittelbarer Nähe eines zu beschichtenden Substrats.

Weiterhin sind ein Verfahren und eine Vorrichtung zur Herstellung von metallfreien Streifen bei der Metallbedampfung eines Isolierstoffbands bekannt (EP 0 756 020 A1). Hierbei wird im Bereich der herzustellenden metallfreien Streifen ein Abdeckband aufgebracht, das mittels eines Ölverdampfers auf einer Seite mit Öl beschichtet wird. Einzelheiten über den Aufbau des Ölverdampfers sind nicht angegeben.

Bei einer anderen bekannten Vorrichtung zum Herstellen von Öl-Maskierungen ist eine zylindrische Maskierungsrolle vorgesehen, in die Maskierungsöl eingegeben wird (JP 2001-279425). Auf dem Umfang der Maskierungsrolle befindet sich eine Öffnung, durch die Maskierungsöl abgegeben wird. Eine dünne Folie mit Durchbohrungen befindet sich über der Rolle, wobei sich die Durchbohrungen mit der Öffnung überlappen.

Eine weitere Vorrichtung, bei der ein Substrat an mehreren linear angeordneten Düsen vorbeigeführt wird, ist aus JP 2004-214185 bekannt. Die dort beschriebene Vorrichtung besteht aus einer mit Öl befüllten kastenförmigen Anordnung, wobei die Heizung unterhalb der Vorrichtung liegt.

Schließlich ist eine Vorrichtung zum bereichsweisen Auftragen von Trennmitteln mittels eines beheizbaren Verdampfers auf bewegte Substrate in einer Vakuumkammer bekannt (EP 1 493 836 A1). Die Vorrichtung weist ein Stellventil auf, mit dem die Menge des Trennmittels sowohl einstellbar als auch vollständig unterbrechbar ist.

Die vorstehend erwähnten Vorrichtungen besitzen keine Möglichkeit, die Menge an ausströmendem Öldampf zu dosieren.

Der Erfindung liegt deshalb die Aufgabe zugrunde, eine Vorrichtung zum Bedampfen von Substraten mit Öl bereitzustellen, die es ermöglicht, die Menge an ausströmendem Öldampf einzustellen.

Die Aufgabe wird gemäß den Merkmalen des Patentanspruchs 1 gelöst.

Die Erfindung betrifft somit eine Vorrichtung zum Bedampfen von Substraten. Sie enthält eine Wanne sowie eine Abdeckung mit linear angeordneten Bohrungen. Oberhalb dieser Abdeckung sitzt eine Absperrvorrichtung, die ebenfalls über Öffnungen verfügt. Durch die Absperrvorrichtung können die Bohrungen der Abdeckung geschlossen oder geöffnet werden, wobei alle Bohrungen gleichzeitig angesprochen werden. Durch die Absperrvorrichtung können innerhalb kürzester Zeit unterschiedliche Verdampfungsraten eingestellt werden.

Die in der vorliegenden Erfindung beschriebene Vorrichtung hat den Vorteil, dass eine wesentlich bessere Gleichmäßigkeit des Dampfdrucks und damit der Ölstreifengenauigkeit über die volle Arbeitsbreite der Folie erzielt wird.

Die Vorrichtung besitzt mehrere Bohrungen, die in einer Reihe angeordnet sind, wobei die Bohrungen mittels einer Absperrvorrichtung geschlossen oder geöffnet werden können. Diese Absperrvorrichtung besitzt ebenfalls Öffnungen, wobei durch Betätigung der Absperrvorrichtung die Bohrungen geschlossen oder geöffnet werden können.

Diese Absperrvorrichtung spricht dabei alle Bohrungen gleichzeitig an, sodass ein gleichmäßiges Öffnen aller Bohrungen ermöglicht wird.

Damit ist es möglich, innerhalb kürzester Zeit eine Verdampfungsrate der thermisch trägen Verdampfervorrichtung einzustellen.

Ein Vorteil der Erfindung besteht darin, dass die Absperrvorrichtung so angeordnet werden kann, dass die Menge an ausströmendem Dampf zu jeder Zeit konstant bleibt. Durch diese konstante Dampfmenge wird auch die Beschichtung des Substrats gleichmäßig, sodass sich die Vorrichtung besonders gut eignet, Streifen, Muster sowie flächige metallfreie Zonen auf metallierten Kunststofffolien zu bilden.

Ein weiterer Vorteil der Erfindung liegt darin, dass der Verdampfungsraum während der Vorbereitung sowie der Beendigung des Aufdampfprozesses mittels der Absperrvorrichtung geschlossen werden kann. Ein Austreten von Öl wird damit unmöglich, womit auch die Verschmutzung der Umgebung mit Öl auf ein Minimum herabgesetzt wird. Der Ölverlust kann somit drastisch reduziert werden. Die Absperrvorrichtung besitzt damit die Möglichkeit, eine offene oder geschlossene Position einzunehmen.

Mit der Möglichkeit, die Menge an ausströmendem Öldampf einzustellen, kann die Ölmenge optimiert werden, sodass es möglich ist, die Qualität der metallfreien Zonen bezüglich der Kantenexaktheit und Restölmengen zu erhöhen. Eine exakte Einstellung kann beispielsweise dadurch erfolgen, dass mittels Messeinrichtungen die Menge an austretendem Öl ermittelt wird. Entspricht die austretende Menge an Öldampf nicht dem

Sollwert, so wird ein Signal an eine Vorrichtung gegeben, über die die Absperrvorrichtung betätigt wird, sodass die Menge an Öldampf wieder auf den Sollwert eingestellt wird.

Ferner ist die Vorrichtung so konzipiert, dass der aufsteigende Dampf die Vorrichtung nur nach oben hin, d. h. zu einer Seite hin, verlassen kann, da diese zu den anderen Seiten hin völlig undurchlässig für den Dampf ist. Dadurch, dass keine Querströmungen mehr auftreten, ist der Dampfdruck in jedem Bereich der Vorrichtung nahezu gleich, wodurch auch keine Strömungswiderstände im Raum unterhalb der Düsen existieren. Durch eine flache Bauweise des Tiegels und der Absperrvorrichtung in Form eines Schiebers kann die Vorrichtung sehr viel kleinere Ausmaße annehmen als die bereits bekannten Verdampferanlagen.

Der Gegenstand der Erfindung ist in den Zeichnungen dargestellt und nachfolgend noch näher erläutert. Es zeigen:
- Fig. 1: eine perspektivische Ansicht einer Vorrichtung zum Bedampfen von Substraten mit Öl mit vorbeigeführtem Substrat;
- Fig. 2: eine perspektivische Ansicht der Vorrichtung gemäß Fig. 1 ohne Substrat und ohne eine Düsenleiste;
- Fig. 3: einen Ausschnitt eines Längsschnitts durch die Vorrichtung gemäß Fig. 1 entlang A-A mit einem Schieber in offener Stellung;
- Fig. 4: einen Schnitt durch die in Fig. 1 gezeigte Vorrichtung entlang B-B nach Drehung dieser um 90° im Uhrzeigersinn mit dem Schieber in offener Stellung.

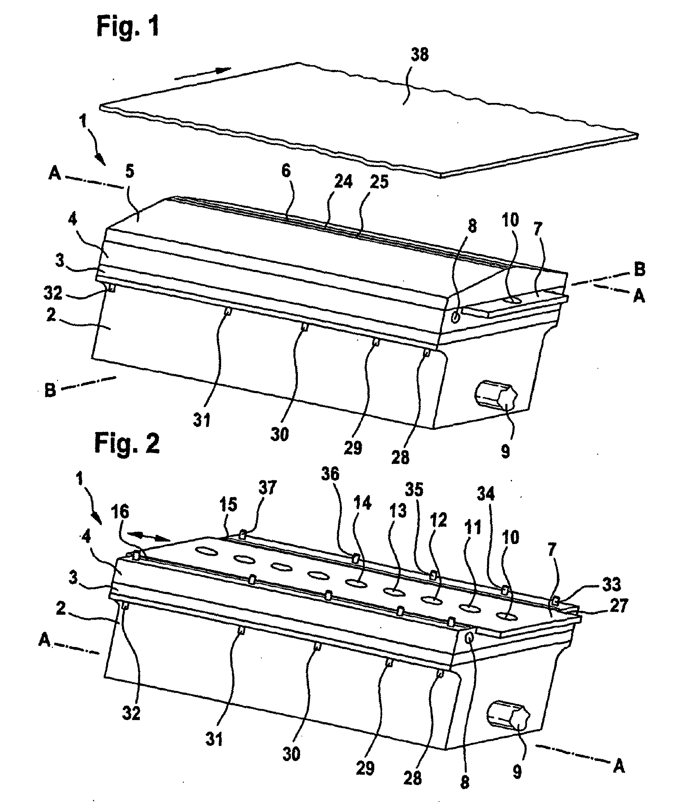

Fig. 1 zeigt eine perspektivische Ansicht einer Vorrichtung 1 zum Bedampfen von Substraten mit Materialien, beispielsweise organischen Materialien im Vakuum. Über die Vorrichtung 1 wird entlang B-B ein flächiges Substrat 38 geführt. Handelt es sich bei dem Substrat um eine Kunststofffolie, so kann diese, wie in JP 2001-279425 beschrieben, über die Vorrichtung 1 bewegt werden. Um scharfkantige Streifen zu erzeugen, ist der Abstand zwischen Substrat 38 und der Vorrichtung 1 meist sehr gering.

Die Vorrichtung 1 besitzt eine Öl-Wanne 2, in der sich zu verdampfendes Öl befindet. Auf dieser Öl-Wanne 2 liegt eine Isolierschicht 3, auf der eine Heizplatte 4 angeordnet ist. Auf der Heizplatte 4 befindet sich eine Düsenleiste 5, die auf ihrer Oberkante einen Spalt 6 aufweist. Statt eines Spalts 6 können auch Einzeldüsen vorgesehen sein. Entlang der Linie A-A ist ein Schieber 7 vorgesehen, der Bohrungen aufweist, von denen man in der Fig. 1 nur die Bohrung 10 erkennt. Der Spalt 6 wird durch zwei Bereiche 24, 25 begrenzt.

Die Vorrichtung 1 weist weiterhin Verbindungselemente 28 bis 32 auf, die die Öl-Wanne 2, die Isolierschicht 3, die Heizplatte 4 sowie die darauf liegende Düsenleiste 5 miteinander verbinden. Die Öl-Wanne 2 verfügt über mindestens eine Heizung, die in Fig. 1 als Stabheizung 9 gezeigt ist. Bei dieser Heizung 9 handelt es sich beispielsweise um eine Widerstandsheizung, die vorzugsweise über eine Wechselspannungsquelle betrieben wird. Durch diese Stabheizung 9 wird das in der Öl-Wanne 2 befindliche Öl verdampft.

Um eine Kondensation des Dampfs im mittleren Bereich der Vorrichtung 1 zu verhindern, verfügt die Heizplatte 4 über mindestens eine separate Stabheizung 8.

Fig. 2 zeigt eine perspektivische Ansicht der in Fig. 1 gezeigten Vorrichtung 1 ohne das Substrat 38 und ohne die Düsenleiste 5. Hierbei erkennt man wieder den Schieber 7, der in der Heizplatte 4 angeordnet ist. Dieser Schieber 7 kann, wie hier dargestellt, die Form einer länglichen Platte annehmen. Die Heizplatte 4 liegt auf der auf der Öl-Wanne 2 sitzenden Isolierplatte 3, wobei Isolierplatte 3, Heizplatte 4 und Öl-Wanne 2 über die Verbindungselemente 28 bis 37 miteinander verbunden sind. Zudem sind die Stabheizungen 9, 8 und 27 zu sehen.

Die Isolierplatte 3 dient der thermischen Entkopplung zwischen der Öl-Wanne 2 und der Platte 4. Mit den getrennten Heizungen, der Stabheizung 8 und der Heizung 9, können damit in der Platte 4 und in der Öl-Wanne 2 verschiedene Temperaturen eingestellt werden. Die Isolierplatte 3 besteht dabei aus einem im Wesentlichen flexiblen Kunststoff, der gleichzeitig als Dichtungsmaterial dient.

Die Heizplatte 4 besitzt in ihrer Mitte entlang der Linie A-A eine Vertiefung, in welche der Schieber 7 eingepasst ist. Dieser Schieber 7 weist mehrere in einer Reihe angeordnete Öffnungen 10 bis 14 auf, die einen im Wesentlichen äquidistanten Abstand zueinander haben. Der Schieber 7 ist entlang A-A (s. Pfeil) verschiebbar. Er muss mindestens so viele Öffnungen 10 bis 14 aufweisen, wie die Heizplatte 4 - in der Fig. 2 nicht erkennbare - Bohrungen besitzt, wobei der Abstand des Mittelpunkts zweier Öffnungen 10 bis 14 dem Abstand des Mittelpunkts zweier Bohrungen in der Heizplatte 4 entspricht. Der Durchmesser der Bohrungen der Heizplatte 4 entspricht im Wesentlichen dem Durchmesser der Öffnungen 10 bis 14 des Schiebers 7. Der Schieber 7 hat somit eine Länge, die der Länge der Heizplatte 4 plus dem Abstand des Mittelpunkts zweier Öffnungen 10 bis 14 entspricht. Dadurch ist es möglich, dass zum einen die Mittelpunkte der Öffnungen 10 bis 14 genau über den Mittelpunkten der Bohrungen und zum andern zwischen den Mittelpunkten der Bohrungen liegen können. Liegen sie genau über den Bohrungen, kann der Dampf aus dem Innern der Öl-Wanne 2 entweichen, liegen sie dagegen zwischen den Bohrungen, ist ein Austritt des Dampfes unmöglich. Zwischen diesen beiden Extremstellungen sind natürlich auch noch Stellungen möglich, in denen der Dampf reduziert entweichen kann. Es können natürlich sehr viel mehr und auch kleinere Öffnungen 10 bis 14 vorgesehen sein, als in Fig. 2 dargestellt.

An den beiden Seiten der Heizplatte 4, die sich entlang A-A erstrecken, ist ein Dichtungsmaterial 15, 16 angeordnet, welches verhindert, dass Dampf aus der Öl-Wanne 2 tritt. Dieses Dichtungsmaterial 15, 16 enthält vorzugsweise gummielastisches Material.

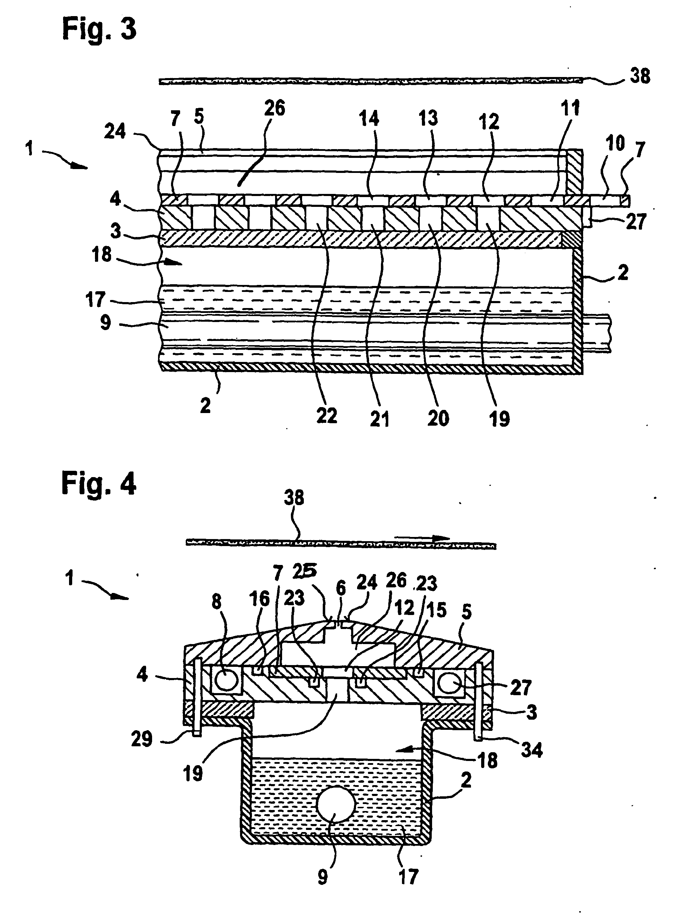

Fig. 3 zeigt einen Ausschnitt eines Längsschnitts durch die Vorrichtung gemäß Fig. 1 entlang A-A. Im Innenraum 18 der Öl-Wanne 2 erkennt man den Heizstab 9, der vollständig von Öl umgeben ist. Auf der Öl-Wanne 2 befindet sich die Isolierplatte 3, auf der die Heizplatte 4 angeordnet ist. Diese Heizplatte 4 verfügt über mehrere Bohrungen 19 bis 22, aus denen der Dampf über die Öffnungen 10 bis 14 des Schiebers 7 in den Zwischenraum 26 aufsteigen kann.

Wie in Fig. 3 zu sehen, liegt ein Teil des Schiebers 7 mit der Öffnung 10 außerhalb der Öl-Wanne 2. Der Schieber 7 ist so auf der Heizplatte 4 angeordnet, dass ein Teil der Öffnungen 12 bis 14 des Schiebers genau mit den Bohrungen 19 bis 21 der Heizplatte 4 abschließt. Der aufsteigende Dampf kann somit über die Bohrungen 19 bis 21 und die Öffnungen 12 bis 14 in den Zwischenraum 26 der Düsenleiste 5 und von dort aus über den Spalt 6 aus der Vorrichtung 1 treten. So gelangt der Dampf auf das Substrat 38, das über die Vorrichtung 1 bewegt wird.

Wird der Schieber 7 weiter in die Vorrichtung 1 geschoben, so kann erreicht werden, dass die Öffnungen 10 bis 12 nur noch teilweise über den Bohrungen 19 bis 22 liegen. Der Schieber 7 wirkt dann wie ein Drosselventil, da weniger Dampf aus der Öl-Wanne 2 treten kann. Wird der Schieber 7 noch weiter in die Vorrichtung 1 geschoben, so wird der Beschichtungsprozess vollständig unterbrochen, da keine der Öffnungen mehr über den Bohrungen 19 bis 22 liegt und es nicht mehr möglich ist, dass Dampf aus der Öl-Wanne 2 entweichen kann.

Fig. 4 zeigt einen Schnitt durch die in Fig. 3 dargestellte Vorrichtung 1 entlang B-B nach Drehung dieser um 90° im Uhrzeigersinn. Dabei wird ein Substrat 38 oberhalb der Vorrichtung 1 vorbeibewegt. Im Innern 18 der Öl-Wanne 2 verläuft der Heizstab 9, der vollständig von Öl 17 umgeben ist.

Auf der Öl-Wanne 2 liegen die Isolierplatte 3 sowie die Heizplatte 4 und die Düsenleiste 5. Alle diese Elemente 2 bis 5 werden über Verbindungsstücke 29, 34 zusammengehalten, sodass sie dicht aneinander liegen, wodurch es nicht möglich ist, dass Dampf an den Seiten der Vorrichtung 1 austreten kann. Durch die Heizplatte 4 verlaufen die beiden Heizstäbe 8 und 27. Zu erkennen ist auch das gummielastische Material 15, 16 sowie das Dichtungsmaterial 23, welches parallel zur Bohrung 19 verläuft. Diese Bohrung 19 ist damit, wie die übrigen Bohrungen 20, 21, 22, auch vollständig von Dichtungsmaterial umgeben.

Auf der Heizplatte 4 liegt der Schieber 7 mit der Öffnung 12, die direkt über der Bohrung 19 liegt. Damit kann der aufsteigende Dampf in den Zwischenraum 26 gelangen. Speziell bei Düsenleisten mit wenig Düsen muss für gleichmäßige Ölstreifen ein Ausgleichen des Dampfdrucks ohne merkliche Strömungswiderstände erfolgen können. Deshalb sollte der Zwischenraum 26 unter den Düsen möglichst groß sein. Die Düsenleiste 5 besitzt einen Spalt 6, der durch die beiden Bereiche 24, 25 definiert ist. Über den Spalt 6 kann der Dampf die Vorrichtung 1 verlassen und auf das vorbeibewegte Substrat 38 gelangen, wo er schließlich kondensiert.

Durch Verschieben des Schiebers 7 wird erreicht, dass die Öffnung 12 nicht mehr oder nur noch teilweise über der Bohrung 19 liegt.

Liegt sie nur teilweise über der Bohrung 19, so wird eine Drosselwirkung erhalten, liegt die Öffnung 12 hingegen nicht mehr über der Bohrung 19, kann kein Dampf mehr austreten. Der Schieber 7 wirkt somit als Absperrventil.

Ist der Beschichtungsprozess abgeschlossen und die Vorrichtung 1 abgekühlt, so können die Verbindungsstücke 29, 34 entfernt und die Anlage bequem auseinander genommen und gereinigt werden.

## Patentansprüche

1. Vorrichtung zum Bedampfen von Substraten, welche eine Wanne (2) sowie oberhalb der Wanne (2) eine Abdeckung (4) aufweist, wobei oberhalb der Abdeckung (4) eine Absperrvorrichtung (7) vorgesehen ist, **dadurch gekennzeichnet, dass** die Abdeckung (4) linear angeordnete Bohrungen (19 - 22) aufweist und dass die Absperrvorrichtung (7) linear angeordnete Öffnungen (10 - 14) aufweist.

2. Vorrichtung nach Anspruch 1, **dadurch gekennzeichnet, dass** die Absperrvorrichtung (7) mindestens so viele Öffnungen (10 -14) aufweist, wie die Abdeckung (4) Bohrungen (19 - 22) aufweist.

3. Vorrichtung nach Anspruch 1, **dadurch gekennzeichnet, dass** die Absperrvorrichtung (7) entlang einer Koordinate beweglich ist.

4. Vorrichtung nach Anspruch 1, **dadurch gekennzeichnet, dass** die Absperrvorrichtung (7) im Wesentlichen eine Länge aufweist, die der Länge der Abdeckung (4) entspricht.

5. Vorrichtung nach Anspruch 1, **dadurch gekennzeichnet, dass** die Absperrvorrichtung (7) mindestens die Länge der Abdeckung (4) plus eine Länge, die dem Abstand des Mittelpunkts zweier Bohrungen (19 - 22) entspricht, aufweist.

6. Vorrichtung nach Anspruch 1, **dadurch gekennzeichnet, dass** der Abstand zwischen den Mittelpunkten zweier benachbarter Öffnungen (10 -14) der Absperrvorrichtung (7) annähernd dem Abstand zwischen den Mittelpunkten zweier benachbarter Bohrungen (19 - 22) der Abdeckung (4) entspricht.

7. Vorrichtung nach Anspruch 1, **dadurch gekennzeichnet, dass** die Absperrvorrichtung (7) eine Position einnimmt, bei der die Mittelpunkte der Öffnungen (10 -14) genau oberhalb der Mittelpunkte der Bohrungen (19 - 22) der Abdeckung (4) liegen.

8. Vorrichtung nach Anspruch 1, **dadurch gekennzeichnet, dass** die Absperrvorrichtung (7) eine Position einnimmt, bei der die Mittelpunkte der Öffnungen (10 -14) genau in der Mitte zweier nebeneinander liegenden Bohrungen (19 - 22) der Abdeckung (4) liegen.

9. Vorrichtung nach Anspruch 1, **dadurch gekennzeichnet, dass** die Wanne (2) mindestens eine Heizung (9) aufweist.

10. Vorrichtung nach Anspruch 1, **dadurch gekennzeichnet, dass** die Abdeckung (4) mindestens eine Heizung (8, 27) aufweist.

11. Vorrichtung nach Anspruch 1, **dadurch gekennzeichnet, dass** zwischen der Wanne (2) und der Abdeckung (4) eine Isolierplatte (3) vorgesehen ist.

12. Vorrichtung nach Anspruch 1, **dadurch gekennzeichnet, dass** oberhalb der Absperrvorrichtung (7) ein Dampf-Zwischenraum (26) in einer Düsenleiste (5) vorgesehen ist.

13. Vorrichtung nach Anspruch 12, **dadurch gekennzeichnet, dass** oberhalb des Dampf-Zwischenraums (26) ein Spalt (6) in der Düsenleiste (5) vorgesehen ist.

14. Vorrichtung nach Anspruch 9 oder Anspruch 10, **dadurch gekennzeichnet, dass** die Heizung (9, 8, 27) eine Stabheizung ist.

## Claims

1. Arrangement for the vapor deposition on substrates, which comprises a pan (2) as well as above the pan (2) a cover (4), whereby above the cover (4) a seal-off device (7) is provided, **characterized in that** the cover (4) includes linearly disposed bores (19-22) and that the seal-off device (7) includes linearly disposed openings (10-14).

2. Arrangement as claimed in claim 1, **characterized in that** the seal-off device (7) has at least as many openings (10-14) as the cover (4) has bores (19-22).

3. Arrangement as claimed in claim 1, **characterized in that** the seal-off device (7) is movable along one coordinate.

4. Arrangement as claimed in claim 1, **characterized in that** the seal-off device (7) has substantially a length which corresponds to the length of the cover (4).

5. Arrangement as claimed in claim 1, **characterized in that** the seal-off device (7) has at least the length of the cover (4) plus a length corresponding to the distance of the center of two bores (19-22).

6. Arrangement as claimed in claim 1, **characterized in that** the distance between the centers of two adjacent openings (10-14) of the seal-off device (7) corresponds approximately to the distance between the centers of two adjacent bores (19-22) of the cover (4).

7. Arrangement as claimed in claim 1, **characterized in that** the seal-off device (7) assumes a position in which the centers of the openings (10-14) lie precisely above the centers of bores (19-22) of the cover (4).

8. Arrangement as claimed in claim 1, **characterized in that** the seal-off device (7) assumes a position in which the centers of the openings (10-14) lie precisely in the center between adjacent bores (19-22) of the cover (4).

9. Arrangement as claimed in claim 1, **characterized in that** the pan (2) has at least one heater (9).

10. Arrangement as claimed in claim 1, **characterized in that** the cover (4) has at least one heater (8, 27).

11. Arrangement as claimed in claim 1, **characterized in that** between the pan (2) and the cover (4) an insulating plate (3) is provided.

12. Arrangement as claimed in claim 1, **characterized in that** above the seal-off device (7) a vapor interspace (26) in a nozzle bar (5) is provided.

13. Arrangement as claimed in claim 12, **characterized in that** above the vapor interspace (26) a gap (6) is provided in the nozzle bar (5).

14. Arrangement as claimed in claim 9 or claim 10, **characterized in that** the heater (9, 8, 27) is a rod heater.

## Revendications

1. Dispositif permettant le revêtement de substrats par évaporation, lequel présente un bac (2) ainsi qu'un couvercle (4) situé au-dessus du bac (2), un dispositif d'obturation (7) étant prévu au-dessus du couvercle (4), **caractérisé en ce que** le couvercle (4) présente des trous (19 - 22) disposés de manière linéaire, et **en ce que** le dispositif d'obturation (7) présente des ouvertures (10 - 14) disposées de manière linéaire.

2. Dispositif selon la revendication 1, **caractérisé en ce que** le dispositif d'obturation (7) présente au moins autant d'ouvertures (10 - 14) que le couvercle (4) présente de trous (19 - 22).

3. Dispositif selon la revendication 1, **caractérisé en ce que** le dispositif d'obturation (7) se déplace le long d'un axe de coordonnées.

4. Dispositif selon la revendication 1, **caractérisé en ce que** le dispositif d'obturation (7) présente essentiellement une longueur qui correspond à la longueur du couvercle (4).

5. Dispositif selon la revendication 1, **caractérisé en ce que** le dispositif d'obturation (7) présente au moins la longueur du couvercle (4) plus une longueur qui correspond à la distance entre les centres de deux trous (19 - 22).

6. Dispositif selon la revendication 1, **caractérisé en ce que** la distance entre les centres de deux ouvertures (10 - 14) voisines du dispositif d'obturation (7) correspond sensiblement à la distance entre les centres de deux trous (19 - 22) voisins du couvercle (4).

7. Dispositif selon la revendication 1, **caractérisé en ce que** le dispositif d'obturation (7) prend une position dans laquelle les centres des ouvertures (10 - 14) se situent exactement au-dessus des centres des trous (19 - 22) du couvercle (4).

8. Dispositif selon la revendication 1, **caractérisé en ce que** le dispositif d'obturation (7) prend une position dans laquelle les centres des ouvertures (10 - 14) se situent exactement à mi-distance entre deux trous adjacents (19 - 22) du couvercle (4).

9. Dispositif selon la revendication 1, **caractérisé en ce que** le bac (2) présente au moins un chauffage (9).

10. Dispositif selon la revendication 1, **caractérisé en ce que** le couvercle (4) présente au moins un chauffage (8, 27).

11. Dispositif selon la revendication 1, **caractérisé en ce qu'**une plaque isolante (3) est prévue entre le bac (2) et le couvercle (4).

12. Dispositif selon la revendication 1, **caractérisé en ce qu'**un espace à vapeur (26) est prévu, au dessus du dispositif d'obturation (7), dans une baguette buse (5).

13. Dispositif selon la revendication 12, **caractérisé en ce qu'**une fente (6) est prévue, au dessus de l'espace à vapeur (26), dans la baguette buse (5).

14. Dispositif selon la revendication 9 ou la revendication 10, **caractérisé en ce que** le chauffage (9, 8, 27) est une tige chauffante.
